**Europäisches Patentamt**

**European Patent Office**

**Office européen des brevets**

(19)

(11) Veröffentlichungsnummer: **0 133 697**

**B1**

(12) # EUROPÄISCHE PATENTSCHRIFT

(45) Veröffentlichungstag der Patentschrift: **22.11.90**

(51) Int. Cl.⁵: **H 04 B 14/04**

(21) Anmeldenummer: **84109260.4**

(22) Anmeldetag: **03.08.84**

(54) **Verfahren zum Übertragen von digitalen Tonsignalen sowie Einrichtung zum Empfangen eines nach diesem Verfahren übertragenen Tonsignals.**

(30) Priorität: **05.08.83 DE 3328344**
**06.07.84 DE 3424813**

(43) Veröffentlichungstag der Anmeldung:
**06.03.85 Patentblatt 85/10**

(45) Bekanntmachung des Hinweises auf die
Patenterteilung:
**22.11.90 Patentblatt 90/47**

(84) Benannte Vertragsstaaten:
**AT BE CH FR GB IT LI LU NL SE**

(56) Entgegenhaltungen:
**EP-A-0 110 352**
**DE-A-2 915 067**
**US-A-3 241 135**

(73) Patentinhaber: **Institut für Rundfunktechnik GmbH**
**Floriansmühlstrasse 60**
**D-8000 München 45 (DE)**

(72) Erfinder: **Twietmeyer, Heinrich**
**Hirschweg 19**
**D-8011 Baldham (DE)**

(74) Vertreter: **Konle, Tilmar, Dipl.-Ing.**
**Benderstrasse 23 a**
**D-8000 München 60 (DE)**

Courier Press, Leamington Spa, England.

EP 0 133 697 B1

**Beschreibung**

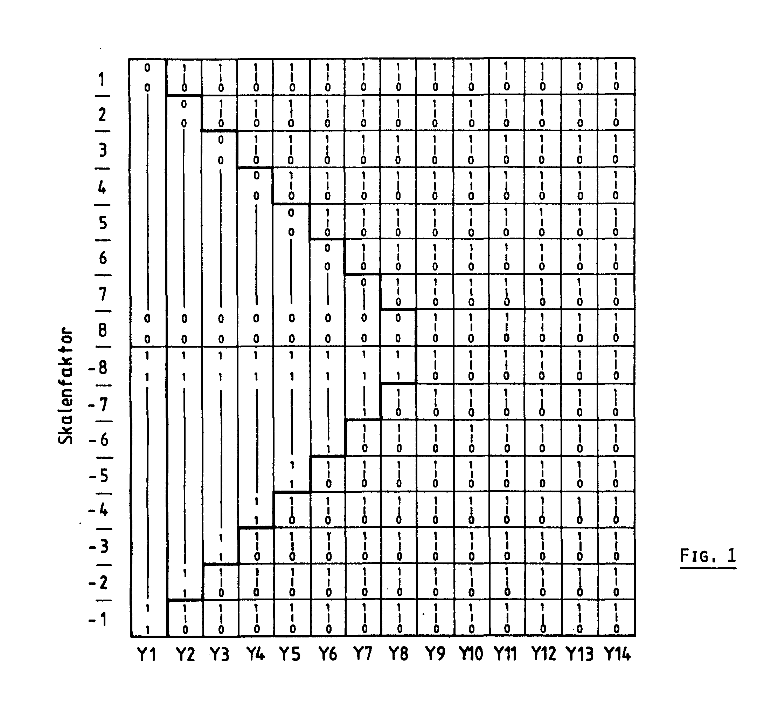

Die Erfindung bezieht sich auf ein Verfahren gemäß dem Oberbegriff des Patentanspruchs 1 sowie auf eine Einrichtung zum Empfangen eines nach diesem Verfahren übertragenen digitalen Tonsignals. Ein Verfahren und eine Einrichtung dieser Art sind aus der DE-A-2 915 067 bekannt. Bei dem aus der DE-A-2 915 067 bekannten Verfahren wird jeweils eine Gruppe von zeitlich aufeinanderfolgenden Abtastwerten von digital codierten Analogsignalen als Datenblock übertragen. Zusätzlich wird für jeden Abtastwert eine Hilfsinformation übertragen, welche den Größenbereich des betreffenden Abtastwertes angibt. Die für die Übertragung der Abtastwerte nicht benötigten, redundanten Binärstellen werden sendeseitig unterdrückt und empfangsseitig mittels der Hilfsinformation regeneriert. Wird das bekannte Verfahren auf Tonsignale angewandt, so zeigt sich aufgrund der statistischen, typischen Größenverteilung aufeinanderfolgender Abtastwerte, daß die zur Übertragung der Hilfsinformationen erforderliche Kanalkapazität einen Großteil der eingesparten Redundanz aufbraucht. Zur Übertragung speziell von digitalen Tonsignalen, insbesondere über Satelliten-Direkt-Rundfunk wird üblicherweise von einem anderen Codierungsschema ausgegangen (E.B.U.-Dokument Com.T 481 (April 1983) "35th Meeting of the Technical Committee", Appendix 3 to Part 3 "Sound Coding Methods"), bei dem die Abtastwerte der digitalen Tonsignale beispielsweise mit einer Auflösung von 14 bit linear (gleichförmig codiert) im sog. Zweier-Komplement-Code übertragen werden. Ein Code-Schema dieses Komplement-Codes ist in Fig. 1 veranschaulicht. Die 14 bit jedes Abtastwortes sind mit Y1 bis Y14 bezeichnet. Alle vorkommenden Bitkombinationen (= Abtastworte) sind in dem Schema in vertikaler Folge aufgezeichnet. Dabei sind diejenigen Kombinationen, deren erstes Bit Y1 eine logische Null enthält, in der oberen Hälte des Schemas veranschaulicht, während diejenigen Kombinationen, deren erstes Bit Y1 eine logische Eins enthält, in der unteren Hölfte des Schemas gezeigt sind. Eine logische Null für das erste Bit Y1 bedeutet nach der Code-Vereinbarung einen positiven Abtastwert. Wie man aus Fig. 1 ferner erkennt, läßt sich jede Hälfte des Schemas insgesamt acht Skalenstufen 1 bis 8 unterteilen, die sich dadurch auszeichnen, daß in der oberen Hälfte bei der ersten Skalenstufe 1 das erste Bit Y1 ausschließlich eine logische Null ist, bei der zweiten Skalenstufe 2 das erste Bit Y1 und das zweite Bit Y2 ausschließlich logische Nullen sind, usw. In der unteren Hälfte des Schemas gilt das entsprechende für die logischen Einsen: Bei der ersten Skalenstufe ist das erste Bit Y1 ausschließlich eine logische Eins, bei der zweiten Skalenstufe 2 sind das erste Bit Y1 und das zweite Bit Y2 ausschließlich logische Einsen usw. Die Skalenstufen 1 bis 8 für jede Hälfte des Schemas zeigen, daß es zur Überprüfung der Richtigkeit einer übertragenen Bitkombination (= Abtastwort) günstig ist, die jeweilige Skalenstufe als "Skalenfaktor" zusammen mit dem zugehörigen Abtastwort zu übertragen.

Man könnte daran denken, die von dem Skalenfaktor repräsentierten MSB's bei der Übertragung wegzulassen und die dadurch frei werdende Übertragungskapazität für Zusatzinformtionen zu nutzen, wie dies an sich aus der DE-A-2 915 067 bekannt ist. Es ist dabei jedoch nicht ohne weiteres ersichtlich, in welchem Datenformat solche Zusatzinformationen in die Tonsignal-Abtastwerte einzuschachteln sind.

Die Aufgabe der Erfindung besteht darin, ein Verfahren der eingangs erwähnten Art zu schaffen, welches generell besser auf die statistische, typische Größenverteilung bei Tonsignalen angepaßt ist und eine entsprechend geringere Übertragungskapazität benötigt sowie im besonderen ein Datenformat angibt, welches eine Abwärtskompatibilität zu gleichförmig (linear) codierten Übertragungssystemen ermöglicht.

Diese Aufgabe wird erfindungsgemäß durch die kennzeichnenden Merkmale des Anspruchs 1 gelöst.

Die Erfindung wird anhand der Zeichnungen näher erläutert. Es zeigt:

Fig. 1 ein bekanntes Code-Schema für den Zweier-Komplement-Code;

Fig. 2 ein bei dem erfindungsgemäßen Verfahren zur Anwendung gelangendes Code-Schema für Zweier-Komplement-Code, wobei im Unterschied zu dem Code-Schema nach Fig. 1 zusätzliche Informationen übertragen werden können;

Fig. 3 ein Ausführungsbeispiel für ein Übertragungsformat nach dem erfindungsgemäßen Verfahren;

Fig. 4 ein Blockschaltbild einer senderseitigen Schaltungsanordnung zur Durchführung des erfindungsgemäßen Verfahrens auf der Sendeseite;

Fig. 5 ein Blockschaltbild einer empfängerseitigen Schaltungsanordnung zur Durchführung des erfindungsgemäßen Verfahrens auf der Empfängerseite;

Fig. 6 ein weiteres Code-Schema, bei dem in Abweichung von dem Code-Schema nach Fig. 2 eine höhere Tonsignalauflösung vorgesehen ist.

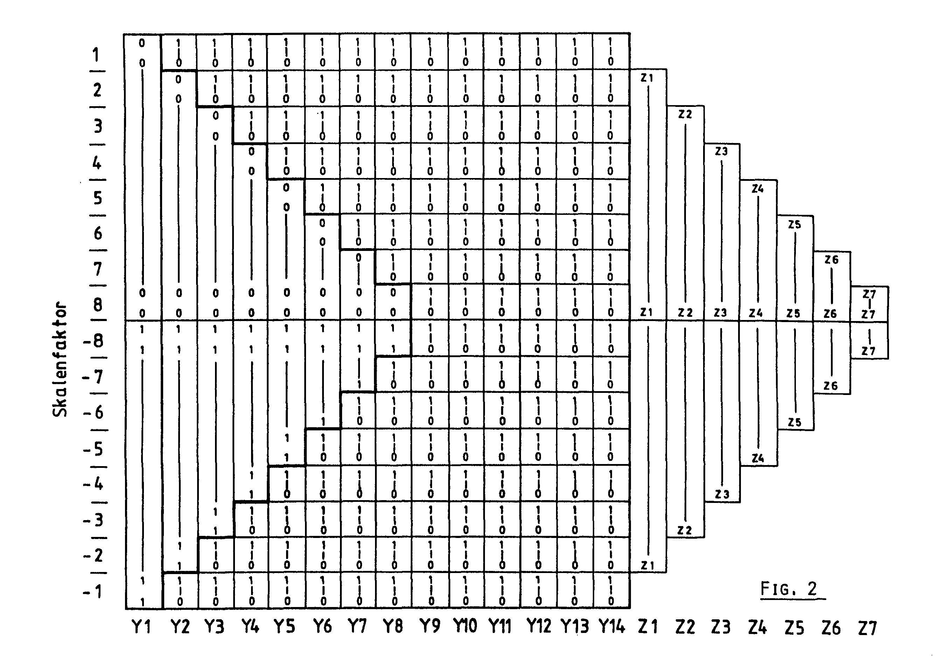

Das Code-Schema nach Fig. 2 beruht auf der Überlegung, daß nicht mehr alle Bits eines Abtastwertes (vgl. Fig. 1: Y1... Y14) übertragen werden, sondern neben dem Vorzeichenbit Y1 nur noch solche Bits, deren Wert sich nicht bereits aus dem Vorzeichenbit und dem Skalenfaktor ergeben; das sind in Fig. 1 neben Y1 die Bits, die sich rechts vom treppenförmigen Muster befinden. Dementsprechend variiert die Anzahl der bei dem erfindungsgemäßen Verfahren übertragenen Bits eines Tonsignals pro Block derart, daß bei großen Skalenfaktoren weniger Tonsignal-Bits pro Block übertragen werden. Wenn der Übertragungsweg eine ausreichend große Kapazität für die Übertragung von stets gleich langen Bitmustern pro Block (z.B. 32 × 14 bit) besitzt, können bei Blöcken mit großem Skalenfaktor die von den Abtastwerten des Tonsignals ungenutzten Bitplätze entsprechend Fig. 2 zur Übertragung von Zusatzinformationen verwendet werden. Bei einem Block mit z.B. einem Skalenfaktor 8 werden dann neben den sieben Bits Y1, Y8, Y9 . . . Y14 des einzelnen Abtastwertes des Tonsignals noch jeweils weitere sieben Bits der Zusatzinformation (Z1 . . . Z7) übertragen, ohne daß hierfür eine höhere Bandbreite des vorgegebenen Übertragungsweges vorzusehen ist.

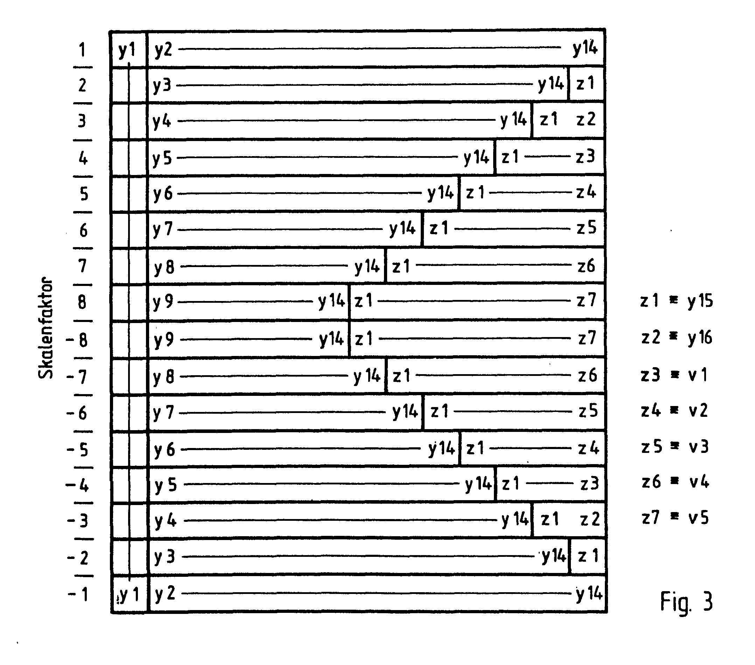

Ein Datenformat, um diese Zusatzinformation zu übertragen, ist beispielsweise in Fig. 3 veranschaulicht. Dieses Datenformat geht von der Überlegung aus, die für die Tonsignalabtastung relevanten Informationsbits, z.B. die Bits Y9 bis Y 14 bei einem Skalenfaktor 8, nach links an das Vorzeichenbit Y1 "heranzuschieben", d.h., daß diese Bits bei der Übertragung die Stellen der höchstwertigen Bits einnehmen. Die dadurch freiwerdenden Stellen der geringwertigen Bits werden entsprechend der verfügbaren Übertragungskapazität mit den Zusatzinformationsbits belegt, im betrachteten Beispielsfall mit den Bits Y15 und Y16 (wobei Y15, Y16 die LSB's für eine 16-bit-Tonauflösung sind und Z1 und Z2 belegen) sowie weitere Bits V1 bis V5, (wobei Y1 bis V5 die LSB's für eine noch weitergehende Tonsignalauflösung in einem 21/14 Bit-Gleitkomma-Übertragungssystem im Sinne einer Aufwärtskompatibilität oder die Bits einer tonsignalfremden Information sein können und die Bits Z3 bis Z7 belegen). Das Datenformat nach Fig. 3 läßt sich indessen ebensogut auch für ein linear codiertes Übertragungssystem nutzen, indem der Skalenfaktor stets zu "O" gesetzt wird.

Der Einsatz von einfacheren Digital/Analog-Wandlern mit geringerer Auflösung von beispielsweise nur 12 oder 14 Bit ist einfach dadurch möglich, indem nach der Übertragung im Datenformat nach Fig. 3 und Umkehrung der "Schiebeoperation" nach Maßgabe des Skalenfaktors nur die Bits Y1 bis Y12 bzw. Y14 an den D/A-Wandler angelegt werden.

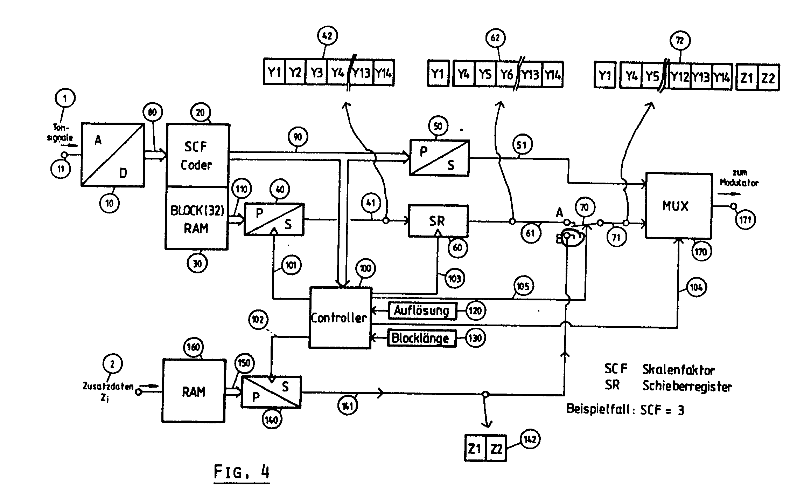

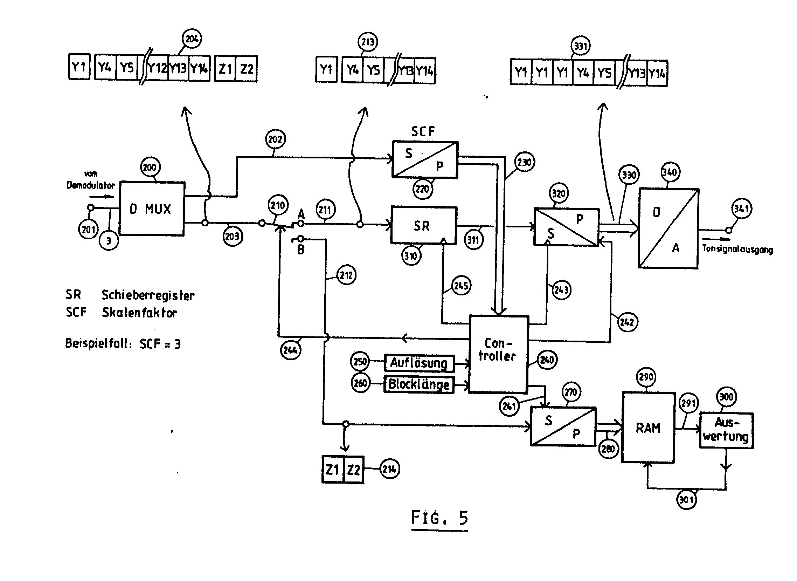

Zur Realisierung der Übertragung von Zusatzinformationen lassen sich beispielsweise die in den Fign. 4 und 5 dargestellten Schaltungsanordnungen für einen Coder und einen Decoder verwenden.

Der in Fig. 4 veranschaulichte, senderseitige Coder enthält unmittelbar nach seinem Eingang 11 einen A/D-Wandler 10, der das Tonsignal 1 abtastet und quantisiert. Die digitalen Abtastwerte 80 werden im Datenformat gemäß dem Zweier-Komplement-Code fortlaufend in einem Speicher 30 mit wahlfreiem Zugriff (RAM) abgespeichert und dabei zu Blöcken von je 32 Abtastwerten zusammengefaßt. Der betragsgrößte Abtastwert des Blockes wird im Skalenfaktorcoder (SCF) 20 festgestellt und zur Bestimmung des Skalenfaktors ausgewertet. Der dem Datenbus 90 zugeführte, codierte Skalenfaktor wird anschließend in einem Wandler 50 parallel/seriell gewandelt, über die Leitung 51 und über einen Multiplexer 170 auf den Ausgang 171 zu dem nicht dargestellten Modulator des Senders gegeben. Dem Multiplexer 170 werden ferner in der nachstehend erläuterten Weise die Abtastwerte des Tonsignals und die Zusatzinformation zugeführt.

Die in dem RAM 30 gespeicherten, digitalisierten Tonsignale werden zusammen mit den in einem weiteren RAM 160 gespeicherten, digitalen Zusatzdaten 2 in Form von Blöcken von jeweils 32 Datenworten, bestehend aus je einem Abtastwort und einer variierenden Anzahl von Zusatzbits, in vier Schritten verarbeitet:

1. Schritt:
Das erste Abtastwort jedes Blockes wird aus dem RAM 30 ausgelesen, über den Bus 110 in einen Parallel/Seriellwandler 40 gegeben und von dort in der benötigten Auflösung (Steller 120) unter der Kontrolle der Ablaufsteuerung 100 in Form des Bitmusters 42 auf die Leitung 41 herausgeschoben Das Bitmuster 42 wird einem Schieberegister 60 angeboten, welches zuerst das Vorzeichenbit Y1 übernimmt.

2. Schritt:
Jene MSB's, die die Ablaufsteuerung 100 entsprechend dem vom Coder 20 über den Bus 90 gelieferten Skalenfaktor als redundant erkennt, werden in einem zweiten Schritt durch den Takt auf der Steuerleitung 101 aus dem Parallel/Seriellwandler 40 ausgegeben, jedoch durch Unterdrückung des Taktes auf der Leitung 103 nicht vom Schieberegister 60 aufgenommen. Diese Arbeitsweise ist anhand der Bitmuster 42 und 62 erkennbar. Hier sind die dem Vorzeichenbit Y1 folgenden zwei höchstwertigen Bits Y2, Y3 als redundant angenommen; bei Verwendung des Zweier-Komplement-Codes haben dementsprechend die drei ersten Bits Y1, Y2, Y3 den gleichen Wert, logisch Null oder logisch Eins. Von diesen drei Bits wird nur das Vorzeichenbit Y1 vom Schieberegister 60 herausgegeben, wodurch sich das Bitmuster 62 ergibt.

3. Schritt:
Erst wenn die redundanten Bits den Wandler 40 verlassen haben, werden die folgenden restlichen Bits gemäß der vom Steller 120 vorgegebenen Auflösung des Abtastwertes vom Wandler 40 zum Schieberegister 60 transportiert und in Form des Bitmusters 62 über die Leitung 61, den Schalter 70 in dessen Position A und über die Leitung 71 dem Multiplexer 170 zugeführt.

4. Schritt:
Nach Ausgabe der Tonsignalinformation berechnet die Ablaufsteuerung 100 aus der mit dem Steller 130 vorgegebenen Blocklänge (32 × 14 Bit), dem vom Coder 20 gelieferten Skalenfaktor und der mit dem Steller 120 vorgegebenen Auflösung der Abtastwerte (14 Bit), wieviele Bitstellen eines Codeswortes noch zur Übertragung der Zusatzdaten 2, die zuvor über den Bus 150 dem Parallel/Seriellwandler 140 zugeführt wurden, zur Verfügung stehen (vgl. Fig. 2). Entsprechend der für die Zusatzdaten 2 ermittelten freien Übertragungskapazität steuert die Ablaufsteuerung 100 über die Taktleitung 102 das Auslesen der Zusatzbits (Z1, Z2) aus dem Wandler 140. Sie werden dann über Leitung 141 als Bitmuster 142 über den Schalter 70, der von der Ablaufsteuerung 100 mittels Steuersignal auf Leitung 105 von der Position A (Tonsignalinformation) auf Position B (Zusatzinformation) gestellt wurde, dem Multiplexer 170 zugeführt. Am Ausgang 71 des Schalters 70 ergibt sich auf diese Weise das Bitmuster 72, aus welchem erkennbar ist, daß die Zusatzinformationsbits Z1, Z2 an die Tonsignalbits angefügt sind. Der Multiplexer 170 arbeitet entsprechend einem Steuersignal von der Ablaufsteuerung 100 über die Leitung 104 derart, daß nach der Ausgabe des Skalenfaktors 32 aufeinanderfolgende Bitmuster 72 ausgegeben werden.

Der empfängerseitig vorgesehene Decoder zum Decodieren der empfangenen Abtastwerte und Zusatzinformationen ist in Fig. 5 veranschaulicht und weist einen bezüglich des Coders nach Fig. 4 analogen Aufbau auf. Der dem Decodereingang 201 nachgeschaltete Demultiplexer 200 trennt von dem digitalen Signal 3, das vom Demodulator des Empfängers kommt, den Skalenfaktor ab, der über die Leistung 202 und einen Seriell/Parallelwandler 220 und den Bus 230 der Ablaufsteuerung 240 zugeführt wird. Mit Hilfe des Skalenfaktors und den von den Stellern 250, 260 vorgegebenen Angaben über die Blocklänge (32 × 14 bit) und die Auflösung (14 bit) decodiert die Ablaufsteuerung 240 die vom Demultiplexer 200 als Bitmuster 204 der Leitung 203 zugeführten Tonsignal- und Zusatzinformationen wortweise, und zwar wiederum jeweils in vier Schritten. Dabei wird das Datenwort (Bitmuster 204) in seine Bestandteile Zusatzdaten 214 und Tonsignalbits 213, 331 zerlegt.

1. Schritt:

Das erste Bit des ersten Wortes jedes Blockes wird über den Schalter 210, der von der Ablaufsteuerung 240 auf Position A (Tonsignalinformation) gestellt wird, über die Leitung 211 in ein Schieberegister 310 eingelesen. Dieses Vorzeichenbit Y1 wird durch einen Steuerbefehl der Ablaufsteuerung 240 auf der Leitung 245 in die zweite Speichereinrichtung 320 eingelesen.

2. Schritt:

Die redundante Tonsignalinformation (im betrachteten Beispielsfall Y2, Y3), die von der Übertragung ausgeschlossen wurde, wird jetzt von der Ablaufsteuerung 240 unter Auswertung des Skalenfaktors rekonstruiert, indem der Wert des im Schieberegister 310 bzw. auf der Leitung 311 stehenden MSB's in der benötigten Anzahl in der Speichereinrichtung 320 entsprechend der Anzahl von Takten, die die Ablaufsteuerung 240 auf der Leitung 243 der Speichereinrichtung 320 zuführt, vervielfacht wird.

3. Schritt:

Anschließend werden die restlichen Bits des Tonsignalabtastwortes vom Schieberegister 310 in die Speichereinrichtung 320 geschoben und dort in paralleles Format gebracht und über den Bus 330 als Bitmuster 331 dem D/A-Wandler 340 formatgerecht zugeführt. An dessen Ausgang 341 steht dann das analoge Tonsignal zur Verfügung.

4. Schritt:

Nach der Rekonstruktion des Tonsignals stellt die Ablaufsteuerung 240 mittels Steuerleitung 244 den Schalter 210 auf Position B (Zusatzinformation) und führt den Rest des übrigen Codewortes auf der Leitung 203, d.h. die Zusatzinformation gemäß Bitmuster 214 über die Leitung 212, den Seriell/Parallelwandler 270, der über die Leitung 241 gesteuert wird, und den RAM-Speicher 290 und über die Leitung 291 der Auswertungslogik 300 zu. Dabei steuert die Logik 300 über eine Steuerleitung 301 den RAM-Speicher 290, der über den Bus 280 mit dem Ausgang des Wandlers 270 gekoppelt ist.

Die erfindungsgemäß geschaffene zusätzliche Übertragungskapazität ist auf natürliche Weise in Worten strukturiert: Die Wortlänge entspricht der Anzahl der Abtastworte eines Blockes. Bei einem Skalenfaktor 3 werden beispielsweise 2 × 32 bit, bei einem Skalenfaktor 2 1 × 32 bit und bei einem Skalenfaktor 1 0 × 32 bit jeweils pro Block übertragen.

Diese zusätzliche Übertragungskapazität kann verschieden genutzt werden: Es können mit dem Signal nicht zusammenhängende Daten (bei einem Rundfunktonsignal z.B. Senderkennung, Verkehrsfunk, Wetterbericht oder Nachrichten in Form von alphanumerischem Text oder Standbildern) oder auf das Signal bezogene Daten (z.B. Programmart, Interpret und Text eines Liedes, Übersetzung eines fremdsprachlichen Beitrages, Angaben zum Originalschalldruckpegel des Tonsignals) übertragen werden.

Die zusätzlich geschaffene Übertragungskapazität kann ferner auch nur teilweise zur Übertragung von Zusatzinformation genutzt werden, um mit der verbleibenden Übertragungskapazität das Tonsignal mit einer höheren Amplitudenauflösung zu übertragen.

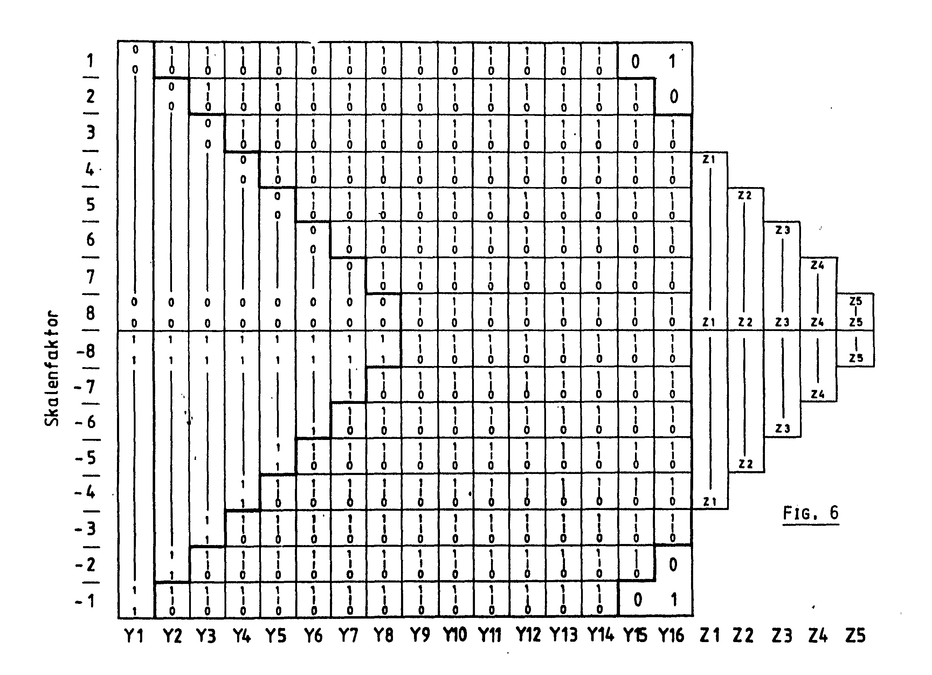

Fig. 6 zeigt am Beispiel, wie bei allen Tonsignalabtastwerten, die einem Skalenfaktor 2 entsprechen, die Auflösung der Abtastwerte um 1 bit auf 15 bit (Y1... Y15) erhöht werden kann; bei Blöcken mit Skalenfaktoren oberhalb von 2 beträgt die Auflösung der Abtastwerte mindestens 16 bit (Y1 bis Y16); die restliche freie Kapazität kann dann wiederum durch Zusatzinformation Z1 bis maximal Z5 belegt werden.

Die Amplitudenauflösung eines digitalen Signals wird — wie oben bereits erläutert u.a. von der begrenzten Übertragungskapazität eines Übertragungsweges bestimmt.

Die so begrenzte Auflösung (Anzahl der pro Abtastwert übertragenen Bits, z.B. 14 bit) führt zu den sogenannten Quantisierungsfehlern: Diese wirken sich bei niedrigen Pegeln eines digitalen Signals meist störender aus als bei hohen Pegeln; bei niedrigen Tonsignalamplituden beispielsweise können diese Fehler als Quantisierungsrauschen eher hörbar werden. Bei hohen Signalpegeln (kleine Skalenfaktoren) entspricht die übertragbare Auflösung der ursprünglichen Auflösung, wie sie ohne Anwendung der Erfindung gegeben ist; mit kleiner werdendem Signalpegel kann mittels der Erfindung der Quantisierungsfehler des Signals zunehmend verringert werden. Dabei wird die Tatsache ausgenutzt, daß bei niedrigen Pegeln die Blöcke des digitalen Signals besonders viele redundante Bits enthalten. Die dann besonders hohe zusätzliche Übertragungskapazität wird verwendet, indem statt der redundanten Bits (z.B. Y2 und Y3) weitere LBS's (Y15 und Y16) übertragen werden, die eine feinere, über die ursprüngliche Genauigkeit hinausgehende Amplitudenauflösung des Signals (Bits Y15, Y16) ermöglichen (vgl. Fig. 6). Auch diese Alternative einer erhöhten Amplitudenauflösung läßt sich mit den Schaltungsanordnungen nach Fign. 4 und 5 realisieren. Aus den Angaben des Skalenfaktors, der Blocklänge und der Auflösung des Tonsignal-Abtastwertes bestimmen die Ablaufsteuerungen 100 bzw. 240 von Coder und Decoder, wie das zu übertragende Codewort aus Zusatzinformation und Tonsignalinformation mit erhöhter Auflösung zusammengesetzt ist. In Empfängern mit geringen Qualitätsansprüchen kann auf die Auswertung der erhöhten Auflösung bei kleinen Signalepegeln verzichtet werden (Abschneiden der LSBs). Die Ablaufsteuerung 240 des Decoders sorgt dabei über die Kontroll-Leitung 242 dafür, daß bei reduzierter bzw. erhöhter Auflösung die Abtastwerte formatgerecht in der vom D/A-Wandler auswertbaren Amplitudenauflösung angeboten werden.

**Patentansprüche**

1. Verfahren zum Übertragen von digitalen Tonsignalen, insbesondere auf Satelliten-Übertragungsstrecken und Übertragungswegen innerhalb des digitalen Fernmeldenetzes, deren Abtastwerte jeweils in einer festgelegten numerischen Genauigkeit als Binärstellen eines einen Abtastwert beschreibenden Bitwortes in Datenblöcken übertragen werden, wobei mit diesen Datenblöcken eine Hilfsinformation mitübertragen wird, welche eine Größenbereichsinformation angibt, wobei sendeseitig bei diesen Datenblöcken die für die Übertragung der Abtastwerte jeweils nicht benötigten, redundanten Binärstellen unterdrückt werden und wobei empfangsseitig die nicht übertragenen Binärstellen jedes Bitwortes nach Maßgabe der Hilfsinformation regeneriert werden, dadurch gekennzeichnet, daß in jedem Datenblock eine festgelegte Anzahl von Bitworten übertragen wird, daß die Hilfsinformation (Skalenfaktor) angibt, in welchem von mehreren Größenbereichen die Amplitude des größten Abtastwertes des betreffenden Datenblockes liegt, daß zur Unterdrückung der redundanten Binärstellen die Werte derjenigen Binärstellen jedes Bitwortes innerhalb eines Datenblockes, welche dem oder den Größenbereichen außerhalb des durch den Skalenfaktor repräsentierten Größenbereiches zugeordnet sind, nicht übertragen werden und daß die Werte der übrigen Binärstellen des betreffenden Bitwortes als höchstwertige Bits des übertragenen Bitwortes verwendet werden.

2. Verfahren nach Anspruch 1, dadurch gekennzeichnet, daß die im übertragenen Datenformat freiwerdenden geringerwertigen Bits jedes Bitwortes eine Zusatzinformation enthalten.

3. Verfahren nach Anspruch 2, dadurch gekennzeichnet, daß die Zusatzinformation einen eine höhere numerische Genauigkeit der Abtastwerte angebenden Stellenwert enthält als er ohne Berücksichtigung des Skalenfaktors im betreffenden übertragungsformat ermöglicht würde.

4. Einrichtung zum Empfangen eines nach den Ansprüchen 1 bis 3 übertragenen digitalen Tonsignals, gekennzeichnet durch folgende Merkmale.

a. Eine erste Trennschaltung (200) zum Abtrennen des Skalenfaktors aus dem empfangenen, demodulierten, digitalen Signal (201);

b. eine Ablaufsteuerung (240), welcher der abgetrennte Skalenfaktor (230), eine Information über die festgelegte numerische Genauigkeit der Abtastwerte des Tonsignals (250) sowie eine Information über die Länge jedes Blockes zugeführt werden (260);

c. eine von der Ablaufsteuerung (240) gesteuerte zweite Trennschaltung (210), welcher das nach Abtrennung des Skalenfaktors verbleibende digitale Signal (203, 204) zugeführt wird und welche hieraus das Zusatzsignal (212, 214) von dem Tonsignal (211, 213) abtrennt;

d. eine erste von der Ablaufsteuerung (240) gesteuerte Speichereinrichtung (270, 290) zum Speichern des abgetrennten Zusatzsignals (212, 214),

e. eine zweite Speichereinrichtung (310, 320), der das Tonsignal (213) zugeführt wird und welche von der Ablaufsteuerung (240) in der Weise steuerbar ist, daß die zur übertragung des Zusatzsignals (212, 214) genutzten binären Stellen nach Maßgabe des Skalenfaktors und des Vorzeichens aufgefüllt werden und

f. ein Digital/Analog-Wandler (340), welcher die aus der zweiten Speichereinrichtung (310, 320) nach Maßgabe der Ablaufsteuerung formatgerecht ausgelesenen Abtastwerte in ein Analogsignal umsetzt.

**Revendications**

1. Procédé pour transmettre des signaux sonores numériques, en particulier sur des liaisons de transmission avec des satellites et des itinéraires de transmission à l'intérieur du réseau de télécommunications numériques, dont les échantillons sont transmis chaque fois, dans des blocs de données, avec une précision numérique fixée, comme des positions binaires d'un mot binaire décrivant un échantillon, selon lequel, ensemble avec les blocs de données, est transmise une information auxiliaire qui indique une information relative à une plage ou intervalle de grandeur, selon lequel, côté émission, s'agissant de ces blocs de données, les positions binaires redondantes non nécessaires à la transmission des échantillons sont supprimées et selon lequel, côté réception, les positions binaires non transmises de chaque mot binaire sont régénérées en fonction de l'information auxiliaire, caractérisé en ce qu'un nombre fixe de mots binaires est transmis dans chaque bloc de données, que l'information auxiliaire (facteur de cadrage) indique dans lequel de plusieurs intervalles de grandeur est située l'amplitude de l'échantillon ayant la valeur la plus élevée du bloc de données concerné, que, pour la suppression des positions binaires redondantes, les valeurs des positions binaires de chaque mot binaire à l'intérieur d'un bloc de données, qui sont coordonnées à l'intervalle ou aux intervalles de grandeur en dehors de l'intervalle de grandeur représenté par le facteur de cadrage, ne sont pas transmises, et que les valeurs des autres positions binaires du mot binaire concerné sont utilisées comme bits de poids fort du mot binaire transmis.

2. Procédé selon la revendication 1, caractérisé en ce que les bits de poids faible, de chaque mot binaire, devenant libres dans le format de données transmis, contiennent une information supplémentaire.

3. Procédé selon la revendication 2, caractérisé en ce que l'information supplémentaire contient une valeur de position indiquant une précision numérique plus élevée des échantillons que celle qui serait possible dans le format de transmission en question s'il n'était pas tenu compte du facteur de cadrage.

4. Dispositif pour recevoir un signal sonore numérique transmis selon les revendications 1 à 3, caractérisé en ce qu'il comprend:

a. un premier circuit de séparation (200) pour séparer le facteur de cadrage du signal numérique (201) reçu et démodulé;

b. une commande séquentielle (240) à laquelle sont appliqués le facteur de cadrage (230) séparé, une information concernant la précision numérique fixée des échantillons du signal sonore (250), ainsi qu'une information sur la longueur de chaque bloc (260);

c. un deuxième circuit de séparation (210), commandé par la commande séquentielle (240), auquel est appliqué le signal numérique (203, 204) qui reste après la séparation du facteur de cadrage et qui sépare dans celui-ci le signal supplémentaire (212, 214) du signal sonore (211, 213);

d. un premier dispositif de mémorisation (270, 290), piloté par la commande séquentielle (240), pour mémoriser le signal supplémentaire (212, 214) séparé;

e. un deuxième dispositif de mémorisation (310, 320), auquel est appliqué le signal sonore (213) et qui peut être piloté, par la commande séquentielle (240), de manière que les positions binaires utilisées pour la transmission du signal supplémentaire (212, 214), soient remplies en fonction du facteur de cadrage et du signe; et

f. un convertisseur numérique/analogique (240) qui convertit en un signal analogique les échantillons extraits du deuxième dispositif de mémorisation (310, 320) avec le format convenable et en fonction de la commande séquentielle.

**Claims**

1. A method of transmitting digital sound signals, especially over satellite transmission routes and transmission channels within the digital telecommunication network, the scanned values of which are each transmitted in data blocks in a determined numerical accuracy as binary positions of a bit word describing a scanned value, wherein there is also co-transmitted with these data blocks an auxiliary information which states information about a size range, wherein, for these data blocks, the redundant binary positions that are not required for the transmission of the scanned values are suppressed at the transmitter side and wherein the non-transmitted binary positions of each bit word are regenerated at the receiver side according to the auxiliary information, characterized in that, in each data block a determined number of bit words is transmitted, that the auxiliary information (scale factor) states in which of several size ranges the amplitude of the largest scanned value of the relevant data block lies, that for the purpose of suppressing the redundant binary positions the values of those binary positions of each bit word within a data block, which are associated with the size range or size ranges outside the size range represented by the scale factor, are not transmitted, and that the values of the remaining binary positions of the relevant bit word are used as highest-value bits of the transmitted bit word.

2. A method according to Claims 1, characterized in that the lower value bits of each bit word which become free in the transmitted data format contain an additional information.

3. A method according to Claim 2, characterized in that the additional information contains a position value giving a higher numerical accuracy of the scanned values than would be possible without taking into account the scale factor in the relevant transmission format.

4. Device for receiving a digital sound signal transmitted according to Claims 1 to 3, characterized by the following features:

a. a first separating circuit (200) for separating the scale factor from the received, demodulated digital signal (201);

b. a run-off controller (240), to which the separated scale factor (230), an information about the determined numerical accuracy of the scanned values of the sound signal (250) and an information about the length of each block are supplied (260).

c. a second separating circuit (210), controlled by the run-off controller (240), to which the digital signal (203, 204) remaining after separation of the scale factor is supplied and which, from this, separates the additional signal (212, 214) from the sound signal (211, 213);

d. a first storage device (270, 290), controlled by the run-off controller (240), for storing the separated additional signal (212, 214),

e. a second storage device (310, 320), to which the sound signal (213) is supplied and which can be controlled by the run-off controller (240) in the manner that the binary positions used for transmitting the additional signals (212, 214) are filled up according to the scale factor and the sign, and

f. a digital/analogue converter (340), which converts the scanned values read out in accordance with format from the second memory device (310, 320) in accordance with the run-off controller, into an analogue signal.

Skalenfaktor

| | 1 | 2 | 3 | 4 | 5 | 6 | 7 | 8 | -8 | -7 | -6 | -5 | -4 | -3 | -2 | -1 |
|---|---|---|---|---|---|---|---|---|---|---|---|---|---|---|---|---|

Y1 Y2 Y3 Y4 Y5 Y6 Y7 Y8 Y9 Y10 Y11 Y12 Y13 Y14

FIG. 1

FIG. 2

z1 = y15
z2 = y16
z3 = v1
z4 = v2
z5 = v3
z6 = v4
z7 = v5

Fig. 3

Skalenfaktor

| | | | |
|---|---|---|---|
| 1 | y1 | y2 ——— y14 | |
| 2 | | y3 ——— y14 | z1 |
| 3 | | y4 ——— y14 | z1 z2 |
| 4 | | y5 ——— y14 | z1 z3 |
| 5 | | y6 ——— y14 | z1 z4 |
| 6 | | y7 ——— y14 | z1 z5 |
| 7 | | y8 ——— y14 | z1 z6 |
| 8 | | y9 ——— y14 | z1 z7 |
| -8 | | y9 ——— y14 | z1 z7 |
| -7 | | y8 ——— y14 | z1 z6 |
| -6 | | y7 ——— y14 | z1 z5 |
| -5 | | y6 ——— y14 | z1 z4 |
| -4 | | y5 ——— y14 | z1 z3 |
| -3 | | y4 ——— y14 | z1 z2 |
| -2 | | y3 ——— y14 | z1 |
| -1 | y1 | y2 ——— y14 | |

FIG. 4

FIG. 5

Fig. 6